# EUROPEAN PATENT APPLICATION

(11) **EP 3 211 789 A1**
(43) Date of publication of application: **30.08.2017**
(21) Application number: 15848531.8
(22) Date of filing: 09.10.2015
(51) Int. Cl.: H02S 40/38, H02J 7/00, H01L 31/042

(54) **SOLAR CHARGER FOR MOBILE DEVICES**

(30) Priority: 10.10.2014 ES 201400789; 07.10.2015 ES 201531442
(71) Applicant: Imaz Mazquiaran, Iñaki, 20018 San Sebastian (ES); Viñas I Aliau, Montserrat I., 20018 San Sebastian (ES)
(72) Inventor: Imaz Mazquiaran, Iñaki, 20018 San Sebastian (ES); Viñas I Aliau, Montserrat I., 20018 San Sebastian (ES)
(74) Representative: Garcia-Cabrerizo y del Santo, Pedro Maria
(86) International application number: PCT/ES2015/070736
(87) International publication number: WO 2016/055686

(57) **Abstract**

The invention relates to a solar charger for devices, designed to be installed in a public space so that users can recharge their mobile devices, wherein the charger comprises: a securing column (1); a photovoltaic solar panel (2) housed in the upper part of the securing column (1); a battery (3) connected to the photovoltaic solar panel (2); a charge controller (5) connected to the battery (3) and to the photovoltaic solar panel (2); at least one module for connecting to a mobile device (4), which is accessible to users and connected to the charge controller (5); and means for securing to the ground, configured to keep the solar charger fixed to the ground.

## Description

### Technical field of the invention

The present invention relates to a solar charger that allows recharging the battery of mobile devices, such as mobile phones, tablets, etc., from solar energy.

### Background of the invention

Different types of chargers for mobile devices, mainly based on the use of electric energy, and even small portable solar chargers, are known from the prior art. Such is, for example, the device disclosed in document ES2253092A1, which describes a portable solar charger for recharging a mobile phone and which, therefore, must be carried by the user in order to be able to use it.

However, the prior art does not disclose any solar charger for mobile devices configured to be installed in a public place so that users can use it whenever they need it without having to carry it with them.

The need to recharge any mobile device in places where a plug is not available is one of the most common drawbacks encountered by users of mobile devices such as mobile phones or tablets.

Thus, the present invention describes a solar charger aimed at covering this social demand, which is becoming increasingly necessary and for which no solution has yet been found that covers all the needs of users and especially of those who need to recharge the battery of their mobile device in public places like streets, squares, bus stops, even in bars and cafeterias with terrace.

### Description of the invention

The solar charger of the present invention is an autonomous device, exclusively powered by solar energy and dedicated to recharge mobile devices such as mobile phones and tablets among others.

The solar charger of the present invention consists of a securing column provided in its upper part, with one or more photovoltaic solar panels (hereinafter reference will be made to only one, although there may be several), which are anchored to said column by means of a support. Preferably the securing column having a frustoconical or cylindrical shape.

The photovoltaic solar panel is connected to a battery. Preferably said battery is located inside a vandal proof cabinet for added protection.

There is a charge controller connected to both the battery and the photovoltaic solar panel. Preferably it is a Maximum Power Point Tracking (MPPT) controller.

In addition, the solar charger comprises at least one module for connection to a mobile device, such as a USB female socket module accessible to users so that they can connect their mobile device when they need to recharge it. This connection module is connected to the charge controller via cables.

Preferably, the charger comprises several USB female socket modules so that multiple devices can be recharged.

The solar charger further comprises ground fastening means configured to hold the solar charger fixed to the ground. These means may be steel bolts encased in concrete blocks to keep the securing column fixed to the ground.

Preferably, the solar charger comprises at least one circular platform attached to the securing column configured as a support for the mobile devices during the charging time.

Preferably, the solar charger includes a circular protection platform attached to the securing column whose functionality is to protect the USB modules from the weather. Thus, this platform is located above the USB female socket modules.

The solar charger is optionally complemented with at least one seat attached to the securing column configured so that users can be seated during the charging time of their mobile device. Preferably it comprises several seats in order to serve a larger number of users.

Another optional element of the solar charger described in the present invention is a circular disk which acts as a sunshade or umbrella to protect the users who are charging their mobile devices. This solar disk is located at the top of the securing column, below the photovoltaic solar panel.

An improvement or complement is the inclusion of a series of sensors and probes: environmental, optical and proximity detectors, anti-theft and/or fire, with the sensors, transmitters and transducers necessary for the study of such data. It may also include audiovisual media, additional power supply elements other than solar energy, wireless media, advertising display elements and lighting.

The solar charger for mobile devices described in the present invention is conceived as an element of urban furniture designed to be integrated in any environment (street, square, terrace, park, etc.), giving citizens a service, with the possibility of recharging their devices while they are in areas where they do not have their device chargers.

### Description of the figures

In order to complete the description and provide a better understanding of the invention, there is attached a figure wherein, with an illustrative and non-limiting character, the following has been represented:

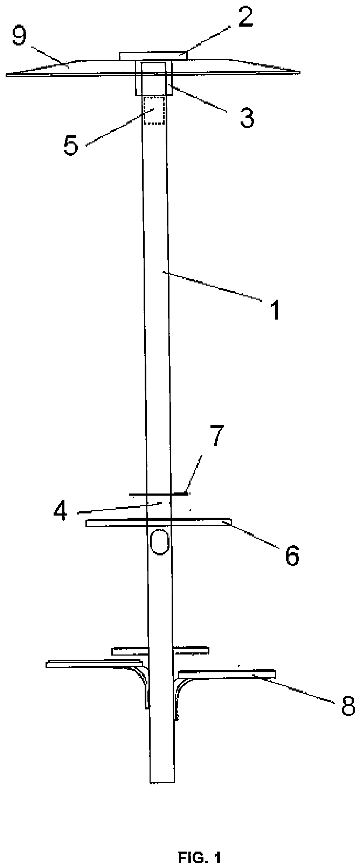

Figure 1 shows a schematic view of the solar charger for mobile devices of the present invention.

The different references that appear in this figure have the following meanings:
1.- Securing column
2.- Photovoltaic solar panel
3.- Battery
4.- Module for connecting to a mobile device
5.- Charge controller
6.- Circular support platform
7.- Circular protection platform for USB modules
8.- Seat
9.- Circular disk

### Detailed description of the invention

Hereinafter, the solar charger for mobile devices of the present invention is described in detail on the basis of the figure presented. The charger consists of a cylindrical securing column (1) three meters high, provided in its upper part with an SOW photovoltaic solar panel (2) of dimensions 1150x535x35mm anchored by means of a support to the securing column (1). The photovoltaic solar panel (2) is connected to a 12V 18Ah battery (3), which, in turn, is located inside a vandal proof cabinet. Connected to both the battery (3) and the photovoltaic solar panel (2) there is a MPPT (5) charge controller to regulate the battery charge by converting the electric current from 12V to 5V. This charge controller (5) is located inside the securing column (1). Connected to the MPPT charge controller (5) are four connection modules (4), with standard USB female socket modules being fed at 5V. These USB female socket modules (4) are accessible to users so that they can connect their mobile devices. The anchoring of the solar charger to the ground is carried out by means of anchoring to the ground (not shown) consisting of steel bolts, preferably 18x500mm, encased in a concrete block.

The charger includes a circular support platform (6) attached to the securing column (1), said platform being configured for holding the mobile devices to be recharged. The solar charger also includes a circular platform for protecting USB modules (7) attached to the securing column (1) and configured to protect the USB female modules (4). It is therefore located above said modules (4).

In this particular embodiment, the solar charger includes three seats (8) attached to the securing column arranged to provide comfort to users during the recharge time of their mobile devices.

Finally, the solar charger includes a circular disk (9) as a sunshade or umbrella located at the top of the securing column (1) below the solar photovoltaic panel (2) to protect users from the sun or rain while they recharge their mobile devices.

In this basic embodiment, the following alternative improvements are made:
- Provision of a series of sensors, which may be arranged at the top, near the photovoltaic solar panels (2), in order not to be easily accessible, or at other points where they can perform their function better.
- Arrangement of audiovisual media, such as a screen for broadcasting information, also including a microphone, a camera and/or a speaker if desired.
- Wireless communication means, Wi-Fi, Bluetooth, infrared, etc.
- Power supply elements for connection to an external source (grid circuit, a generator, etc.) that can serve as support for the photovoltaic solar panels (2) in case of reduced uptake (at night, on cloudy days, indoors...) to be able to operate the equipment. They can also be used to supply more power when necessary, for example for charging batteries of electric vehicles (bicycles, wheelchairs, Segways®, electric cars...) for which it will have its proper connection, which can be by induction (just like the connection modules (4)).
- Lighting.
- Data collection and management devices
- Payment devices

The sensors may be one or more of the following types:
Alarm: one or more proximity, vibration, infrared or movement sensors if it is anti-theft, or temperature or gradient of the same sensors if it is fire-fighting. Preferably, the essential parts are included in the vandal proof cabinet, and the electrical installation of the anti-theft or fire-fighting sensors have means to check their integrity (ammeter...), triggering the alarm in case of unexpected failure. Mean of audio, video or connections to a central alarm are included. This way, alarm means arranged in a distributed form may be provided, preferably overlapping the areas covered by them, always detecting the entry of unauthorized persons or possible fire into the area covered by the sensors.
Environmental: to use the system as a small meteorological unit or to monitor air quality (quantity of ozone, nitrogen oxides, particles, pollen...), noise or light pollution. Proximity: optical sensors to activate lighting devices, audiovisual media, depending on the type of need to cover. In the first case, it may comprise an internal clock, or a detector of the energy generated by the photovoltaic solar panels (2) to know if it is really necessary to provide illumination to the user.

All these sensors are commercially available, so it is not necessary to detail them further.

As for the audiovisual media, they generally comprise a screen, a camera, with sound for sending any type of information, or with input means (keyboard, touch screen) to allow communication with the computer system. If wireless communications means are available, they may be used to communicate with a central system. An example of application is to place orders in a bar or restaurant from the terrace and without the need for a waiter or to provide tourist information. It may also be used to read information from the sensors or to download applications (app) for mobile phones or tablets, including, where necessary, means of payment (these means oaf payment, physical (cards or bills or coins receiver) or by connection to a server such as PaypalS may be required to activate any of the services of the charger).

Preferably, the audiovisual media and the communication media collaborate to create an emergency button for contact with the local emergency services (telephone 112 in the EU, 911 in the URSA).

The data captured by the improved solar charger, either the sensors or the input means, are stored in a memory and/or sent to the central system for processing. For example, in the case of a network, they can be sent to a control center of the city hall, hotel, social club, entertainment park... which collects information from environmental sensors, from the use by users (to add chargers in areas where it is widely used or define traffic maps of electric vehicles, or any other use that is defined).

They may also take advantage of the system as a hotspot or similar point for WiFi internet connection.

Any free surface can be used to include information on advertising, informative (maps, tourist ...) or any other type. Moreover, beacons can be installed to facilitate the localization of users by a method of "beacons", an alternative to GPS that does not require the use of data (of special interest to foreign tourists). This network of beacons may transmit tourist or commercial information.

## Claims

1. Solar charger for mobile devices **characterized by** comprising:
- a securing column (1),
- a photovoltaic solar panel (2) housed in the upper part of the securing column (1) and anchored thereto by means of a support,
- a battery (3) connected to the photovoltaic solar panel (2),
- a charge controller (5) connected to both the battery (3) and the photovoltaic solar panel (2),
- at least one module (4) for connecting to a mobile device accessible to the users of the solar charger and connected to the charge controller (5), and
- ground anchoring means configured to keep the solar charger fixed to the ground.

2. A solar charger for mobile devices according to claim 1, wherein the module (4) for connecting to a mobile device is a USB female module.

3. A solar charger for mobile devices according to claim 1, **characterized by** comprising a circular support platform (6) attached to the securing column (1) configured to hold the mobile devices to be charged.

4. A solar charger for mobile devices according to claim 1, **characterized by** comprising a circular protection platform (7) attached to the securing column (1) configured to protect the USB female modules (4).

5. A solar charger for mobile devices, according to claim 1, **characterized by** comprising at least one seat (8) attached to the securing column (1).

6. A solar charger for mobile devices according to claim 1, **characterized by** comprising a circular disk (9) as a sunshade or umbrella at the top of the securing column (1) and below the photovoltaic solar panel (2).

7. A solar charger for mobile devices according to claim 1, wherein the charge controller (5) is a maximum power point tracking controller.

8. A solar charger for mobile devices, according to claim 1, **characterized in that** the battery is inside a vandal proof cabinet.

9. A solar charger for mobile devices, according to claim 1, **characterized in that** the ground anchoring means consists of steel bolts encased in a concrete block.

10. A solar charger for mobile devices according to claim 2, wherein the controller comprises a securing column (1) three meters high, an 80W photovoltaic solar panel (2) of dimensions 1150x535x35mm, a 12V 18Ah battery (3), a maximum power point tracking controller (5) configured to regulate the battery charge (2) by converting the electric current from 12V to 5V and four USB female modules.

11. A solar charger according to claim 1, further comprising anti-theft alarm and/or fire alarm sensors and/or environmental sensors and/or proximity sensors.

12. A solar charger, according to the preceding claim, wherein the sensors are of alarm, anti-theft and/or fire-fighting, and its electrical installation has means to versify its integrity.

13. A solar charger according to claim 1, further comprising audiovisual means.

14. A solar charger, according to claim 1, comprising wireless communication means.

15. A solar charger according to claims 13 and 14, comprising an emergency button connected to the emergency services.

16. A solar charger according to claim 14 comprising a WiFi hotspot device or similar.

17. A solar charger according to claim 1, further comprising power supply elements.

18. A solar charger according to the preceding claim, comprising a connection configured to charge an electric vehicle.

19. A solar charger according to claim 1, further comprising lighting elements.

20. A solar charger, according to claim 1, further comprising display advertising elements.
